# EUROPÄISCHE PATENTANMELDUNG

(11) **EP 2 330 386 A2**
(43) Veröffentlichungstag der Anmeldung: **08.06.2011**
(21) Anmeldenummer: 10186350.4
(22) Anmeldetag: 04.10.2010
(51) Int. Cl.: G01D 5/12, H01H 19/54

(54) **Drehknopf mit Einrastungen**

(30) Priorität: 19.11.2009 DE 102009053676
(71) Anmelder: Windhorst Beteiligungsgesellschaft mbH, 53119 Bonn 1 (DE)
(72) Erfinder: Grönefeld, Martin, 5127 Bonn (DE)
(74) Vertreter: Lippert, Stachow & Partner

(57) **Zusammenfassung**

Die Erfindung betrifft eine Einstellvorrichtung (1, 100) zur manuellen Einstellung eines Sollwertes mit einem Drehknopf (10, 10', 110), einem gegenüber dem Drehknopf feststehenden Basisteil (20, 220), sowie einer am Drehknopf befestigten und mit diesem relativ zum Basisteil bewegbaren ersten Permanentmagneteinrichtung und einer an dem Basisteil angeordneter Sensoreinrichtung (30, 130) mit zugeordneter Auswerteelektronik zur Erfassung einer Drehstellung des Drehknopfs. Die erfindungsgemäße Einstellvorrichtung zeichnet sich dadurch aus, dass eine ringförmige Scheibe (40, 140) aus magnetisierbarem Material vorgesehen ist, welche mit einer dieser zugeordneten zweiten Permanentmagneteinrichtung zur Erzeugung einer sich zwischen der magnetisierbaren Scheibe und der Permanentmagneteinrichtung einstellenden axialen magnetischen Anziehungskraft zusammenwirkt, wobei die magnetisierbare Scheibe und die zweite Permanentmagneteinrichtung in Einbaulage auf Anlage und bewegbar zueinander angeordnet sind und aneinander anliegende Oberflächen (80, 90, 41; 171, 145) der magnetisierbarer Scheibe und der zweiten Permanentmagneteinrichtung zur Einstellung einer vorgegebenen Haptik bei der Betätigung des Drehknopfes (10, 10', 110) gestaltet sind. (Fig. 1)

## Beschreibung

Die Erfindung betrifft eine Einstellvorrichtung zur manuellen Einstellung eines Sollwertes mit einem Drehknopf, einem gegenüber dem Drehknopf feststehenden Basisteil, sowie einer am Drehknopf befestigten und mit diesem relativ zum Basisteil bewegbaren ersten Permanentmagneteinrichtung und einer an dem Basisteil angeordneter Sensoreinrichtung mit zugeordneter Auswerteelektronik zur Erfassung einer Drehstellung des Drehknopfs.

Eine derartige Vorrichtung ist beispielsweise im Gebrauchsmuster G 8130371 offenbart. Bei dieser gattungsbildenden Vorrichtung ist die erste Permanentmagneteinrichtung als einteiliger Ring mit permanentmagnetischen Abschnitten entgegen gesetzter Polarität ausgebildet, wobei radial außen zu diesem Ring ein mit dem permanentmagnetischen Abschnitten zusammenwirkendes ortsfestes Rastteil aus magnetisch leitendem Material vorgesehen ist. Darüber hinaus sind Rasteinrichtungen für ein drehstellbares Bauelement bekannt, wie sie beispielsweise in der Gebrauchsmusterschrift DE 202 203 79 U1 oder der deutschen Patentschrift DE 39 42 811 C2 beschrieben sind. Dabei umfasst die Rasteinrichtung ein mit dem Drehknopf bewegtes Stahlrad, das an seinem Umfang ausgeklinkt ist und einen radial außen zu dem Stahlrad und je nach Drehlage des Stahlrades auf eine Klinke magnetisch einwirkenden, ortsfesten Magneten. Durch die beschriebene Anordnung werden vorgegebene Winkellagen des Stahlrades und damit des Drehstellers magnetisch verrastet.

Der Erfindung liegt die Aufgabe zugrunde, eine gattungsbildende Einstellvorrichtung funktionell weiterzubilden und insbesondere die Haptik, d.h. den taktilen Eindruck bei der Betätigung der Vorrichtung weiterzuentwickeln.

Diese Aufgabe löst die Erfindung auf überraschende Weise schon mit einer Einstellvorrichtung mit den Merkmalen von Anspruch 1. Die erfindungsgemäße Einstellvorrichtung zeichnet sich dadurch aus, dass eine ringförmige Scheibe vorgesehen ist, welche ein magnetisierbares Material umfasst, wobei die Scheibe mit einer dieser zugeordneten zweiten Permanentmagneteinrichtung zur Erzeugung einer sich zwischen der Scheibe und der Permanentmagneteinrichtung einstellenden axialen magnetischen Anziehungskraft zusammenwirkt, wobei die ringförmige Scheibe und die zweite Permanentmagneteinrichtung in Einbaulage auf Anlage und bewegbar zueinander angeordnet sind und einander anliegende Oberflächen der Scheibe und der zweiten Permanentmagneteinrichtung zur Einstellung einer vorgegebenen Haptik bei der Betätigung des Drehknopfs gestaltet sind.

Die erfindungsgemäße Einstellvorrichtung zeichnet sich gegenüber den bekannten Einstellvorrichtungen insbesondere dadurch aus, dass eine größere Flexibilität in Bezug auf die Einstellmöglichkeiten der Haptik der Vorrichtung an den jeweiligen Anwendungsfall bereitgestellt werden kann. Während herkömmliche Einstellvorrichtungen zur manuellen Einstellung eines Sollwertes mit einem Drehknopf, welche die Drehstellung mittels einer Permanentmagneteinrichtung und einer zugeordneten Sensoreinrichtung erfassen, die Ausnutzung einer berührungslosen Rastung zur Gestaltung einer Haptik mittels Magneten beschreiben, wird bei der erfindungsgemäßen Einstellvorrichtung die Verwendung einer ringförmigen Scheibe aus magnetisierbarem Material gelehrt, welche mit einer zugeordneten Permanentmagneteinrichtung zum Einstellen einer mit Bezug auf den Drehknopf axialen magnetischen Anziehungskraft zwischen der Scheibe und der zugeordneten Permanentmagneteinrichtung zusammenwirkt und beide Teile gegenseitige Anlageflächen aufweisen, welche bei der Betätigung des Drehknopfs gegeneinander bewegt werden. Insofern kann durch die spezifische Gestaltung dieser gegeneinander bewegten Oberflächen als auch durch die Einstellung der Magnetkraft zwischen der Scheibe und der zweiten Permanentmagneteinrichtung, beispielsweise durch die Auswahl und die geometrische Anordnung von Permanentmagnet und/oder magnetisierbaren Material sehr genau und abhängig von der jeweiligen Drehstellung des Drehknopfs der taktile Eindruck für den Benutzer eingestellt werden.

Es sei darauf hingewiesen, dass die zur Anlage kommenden Oberflächen der Scheibe und der zweiten Permanentmagneteinrichtung gemäß der Lehre der Erfindung nicht vollflächig anliegen müssen. Stattdessen kann es sehr wohl sein, dass die Flächenkontakte je nach Gestaltung der jeweiligen Oberfläche in Bezug auf die Gesamtoberflächen vergleichsweise gering sind. Beispielsweise liegt es auch im Rahmen der Erfindung, mehrere - im theoretischen Sinne - eine oder mehrere Punktauflagen vorzusehen, wobei der Fachmann erkennt, dass auch in diesem Fall in der Praxis eine Flächenauflage vorliegt.

Vorteilhafte Ausführungsformen sind in den Unteransprüchen angegeben.

Es kann zweckmäßig sein, wenn die magnetisierbare Scheibe an dem zum Drehknopf feststehenden Basisteil befestigt ist und die zweite Permanentmagneteinrichtung am Drehknopf befestigt ist, sodass so dass letztere mit diesem und damit relativ zum Basisteil bewegt wird. Vorteilhafterweise kann dabei die Scheibe zentrisch zur Drehachse des Drehknopfs angeordnet sein. Eine derartige Ausbildung vereinfacht den Aufbau der Einstellvorrichtung, da beide Permanentmagneteinrichtungen am Drehknopf befestigt und mit diesem bewegt werden.

Andererseits kann es in einer anderen Ausführungsform auch zweckmäßig sein, wenn die magnetisierbare Scheibe zentrisch zur Drehachse des Drehknopfs an diesem befestigt ist und die zweite Permanentmagneteinrichtung an dem gegenüber dem Drehknopf feststehenden Basisteil befestigt ist. Wie in der vorhergehenden Ausführungsform, sorgt das Feld der zweiten Permanentmagneteinrichtung zur Magnetisierung der Scheibe und damit zum Einstellen einer axialen Anziehungskraft zwischen diesen beiden Teilen.

Bei der erfindungsgemäßen Stellvorrichtung erfasst die Sensoreinrichtung die Drehstellung des Drehknopfs, genauer die Drehstellung der mit dem Drehknopf bewegungsverbundenen ersten Permanentmagneteinrichtung dadurch, dass die Orientierung der von der ersten Permanentmagneteinrichtung sich erstreckenden Feldlinien erfasst wird. Hierzu ist eine Vielzahl von Sensoreinrichtungen bekannt, welche beispielsweise auf dem Halleffekt oder dem anisotropen magnetoresistiven Effekt beruhen. Da derartige Sensoren wohl bekannt sind, muss im Folgenden darauf nicht weiter eingegangen werden.

Es hat sich als besonders zweckmäßig herausgestellt, wenn die erste Permanentmagneteinrichtung einen Permanentmagneten umfasst, der auf der zur Sensoreinrichtung gerichteten Stirnfläche eine zweipolige Magnetisierung aufweist, wobei die Sensoreinrichtung einen Magnetfeldwinkel innerhalb der Ebene senkrecht zur Drehachse erfasst. In weiteren Ausführungsformen kann der Permanentmagnet jedoch an der zur Sensoreinrichtung gerichteten Stirnseite höherpolige Magnetisierungen aufweisen, beispielsweise eine vierpolige Magnetisierung.

Bei der Ausführungsform, bei welcher die magnetisierbare Scheibe an dem feststehenden Basisteil befestigt ist, kann zweckmäßigerweise zur Vereinfachung des Aufbaus die erste Permanentmagneteinrichtung und die zweite Permanentmagneteinrichtung zusammen einen einteiligen Permanentmagnet aufweisen, der auf der zur Sensoreinrichtung gerichteten Stirnseite Abschnitte unterschiedlicher Magnetisierung aufweist, wobei zur Gestaltung einer der magnetisierbaren Scheibe zugeordneten zweiten Permanentmagneteinrichtung radial außen liegende Abschnitte der Permanentmagneten eine umfänglich angeordnete, mehrpolige Magnetisierung aus radialen Segmenten, insbesondere mit einer Abfolge von Nord- und Südpolen, zur magnetisierbaren Scheibe hin aufweisen. Dabei kann der einteilige Permanentmagnet wie oben stehend schon beschrieben auf der zur Sensoreinrichtung gerichteten, hier radial inneren Stirnseite eine zweipolige oder höherpolige Magnetisierung aufweisen, deren Magnetfeld von der Sensoreinrichtung erfasst wird. Die radial außen liegenden Abschnitte des Permanentmagneten, in einem umfänglichen Ring angeordnete Abfolge von Nord- und Südpolen dienen zur ortsaufgelösten Magnetisierung der zugeordneten Scheibe, derartig, dass eine axial gerichtete Anziehungskraft zwischen der Scheibe und des Permanentmagneten erzeugt wird.

Im Rahmen der Erfindung kann bei der beschriebenen integralen Ausführung der ersten und zweiten Permanentmagneteinrichtung mit einem einteiligen Permanentmagneten auch vorgesehen sein, dass sowohl der innere Stirnabschnitt des Permanentmagneten zur Bereitstellung der ersten Permanentmagneteinrichtung als auch die radial außen liegenden Abschnitte des Permanentmagneten der zweiten Permanentmagneteinrichtung jeweils zur Sensoreinrichtung bzw. zur Ringscheibe hin gerichtet jeweils nur einen einzelnen Nord-Südpolwechsel, d.h. eine zweipolige Magnetisierung aufweisen.

Wie in allen Ausführungsformen der Erfindung, kann auch hier der Permanentmagnet einen kunststoffgebundenen Magnetwerkstoff umfassen, bei dem ein magnetisierbarer Füllstoff in eine Kunststoffmatrix eingebunden ist. Dieser kann beispielsweise Ferrite und/oder selten Erdwerkstoffe umfassen. Nach der Herstellung eines derartigen Magnetwerkstücks aus einem kunststoffgebundenen Magnetwerkstoff wird dieser in herkömmlicher Weise ortsabhängig magnetisiert zur Erzeugung der beschriebenen mehrpoligen Magnetisierungsbereiche an dem einteiligen Permanentmagneten. Eine derartige Ausbildung kann sowohl bei einem Permanentmagneten der ersten als auch der zweiten Permanentmagneteinrichtung durchgeführt sein sowie - wie beschreiben - bei einem Permanentmagneten einer Ausführungsform, bei welcher die erste und zweite Permanentmagneteinrichtung integral ausgebildet sind und zusammen einen einzelnen Permanentmagneten umfassen.

Zur Zentrierung des Drehknopfs relativ zur drehfesten Basis kann vorgesehen sein, dass die erste Permanentmagneteinrichtung so angeordnet ist, dass sie sich axial zur Drehachse des Drehknopfs in einen Innenbereich der ringförmigen magnetisierbaren Scheibe hinein erstreckt. Dabei ist es zweckmäβig, wenn der zum Sensor gerichtete vordere Abschnitt der ersten Permanentmagneteinrichtung einen geringfügig kleineren Durchmesser als der Innendurchmesser der magnetisierbaren Scheibe ist, um ein möglichst geringes radiales Spiel bereitzustellen. Bei der Ausführungsform, bei welcher zweite und erste Permanentmagneteinrichtung integral mit einem einteiligen Permanentmagneten ausgebildet sind, kann vorgesehen sein, dass dieser an der zur Sensoreinrichtung gerichteten Stirnfläche abgestuft ist, wobei die vordere Stirnfläche die Magnetisierung aufweist, welche von der Sensoreinrichtung erfasst wird und ein davon radial außen abgesetzter Flansch eine mehrpolige Magnetisierung mit einer Abfolge von Nord- und Südpolen zur magnetischen Wechselwirkung mit der magnetisierbaren Scheibe zur Erzeugung einer Anziehung zwischen dem Permanentmagneten und der Scheibe.

Um eine rastende Haptik des Drehknopfes bereitzustellen, kann vorgesehen sein, dass die zugeordneten, aneinander anliegenden Oberflächen von magnetisierbarer Scheibe und zweiter Permanentmagneteinrichtung zur Bereitstellung einer Vielzahl von Raststellungen bei einer gegenseitigen Verdrehung zueinander ausgebildet sind. Eine Raststellung kann sich dabei dadurch auszeichnen, dass sie eine stabile Ruhelage der zueinander bewegten und aneinander liegenden, zugeordneten Oberflächen darstellt, die mittels Aufbringen von Betätigungskraft am Drehknopf durch den Benutzer aufhebbar ist.
Dabei kann die Sensoreinrichtung zur kontinuierlichen oder diskontinuierlichen Erfassung der Drehlage des Drehknopfes ausgebildet sein. Die Anzahl der bereitgestellten Raststellungen über eine vollständige Drehung von 360 Grad kann leicht auf den jeweiligen Anwendungsfall, insbesondere auch an die Sensorgenauigkeit angepasst werden.

Dabei kann die Gestaltung der aneinander anliegenden Oberflächen der Scheibe sowie der zweiten Permanentmagneteinrichtung so ausgebildet sein, dass sich bei der Betätigung des Drehknopfs zwischen benachbarten Raststellungen die zweite Permanentmagneteinrichtung und damit der Drehknopf axial zum Basisteil verschiebt. Beispielsweise können die beiden Oberflächen so ausgebildet sein, dass sich bei einer Betätigung des Drehknopfs zunächst ausgehend von einer Raststellung der axiale Abstand des Drehknopfs zum Basisteil kontinuierlich erhöht und beim Erreichen der nächstliegenden Raststellung schlagartig erniedrigt, wodurch ein besonderer taktiler Eindruck bei der Betätigung des Drehknopfs erzeugt wird.

Zur Erzielung eines symmetrischen taktilen Eindrucks kann vorgesehen sein, dass die axiale Lage des Drehknopfs zum Basisteil bei allen einstellbaren Rastlagen gleich ist. Je nach Anwendung kann es jedoch auch zweckmäßig sein, wenn die axiale Lage des Drehknopfs zum Basisteil sich bei einer vorgegebenen Anzahl von auseinander folgenden Raststellungen jeweils erhöht, um dann schlagartig wieder auf einen Grundwert abzufallen. Auf diese Weise können der Betätigungsperson beispielsweise eine vorgegebene Anzahl von Raststellungen signalisiert werden, beispielsweise jede fünfte oder jede zehnte Raststellung.

Zur Gestaltung der aneinander anliegenden Oberflächen der Scheibe und der zweiten Permanentmagneteinrichtung kann vorgesehen sein, dass eine dieser Oberflächen in Umfangsrichtung eine axiale Strukturierung, wie eine trapez-, stufen-, sägezahn- oder wellenartige Struktur, welche ferner in Umfangsrichtung segmentiert sein kann aufweist, wobei die Strukturierung als Steuerfläche für mehrere, beispielsweise zwei oder drei umfänglich beabstandete, nockenartige und an der zugeordneten Oberfläche angeordnete Vorsprünge ausgebildet sind. Besonders zweckmäßig ist es, wenn sich eine derartige Oberfläche aus einer Vielzahl solcher Segmente zusammensetzt und zwischen umfänglich benachbarten Segmenten gerade eine Raststelle angeordnet ist. Diese Segmente können zur Einstellung einer bestimmten Haptik identisch ausgebildet sein, d.h. als identische Segmente, die sich umfänglich aneinanderreihen. Andererseits ist es auch möglich, dass eine gewisse Anzahl der Segmente z.B. jede fünfte oder jedes zehnte unterschiedlich strukturiert ist, z.B. in Bezug auf die axiale Steigung, so dass auch hierdurch ein spezifischer taktiler Eindruck bei der Betätigung des Drehknopfes eingestellt ist.

Dabei kann die beschriebene axiale Strukturierung je nach Ausführungsform an der magnetisierbaren Scheibe oder an der zweiten Permanentmagneteinrichtung vorgesehen sein. Entsprechend können die nockenartigen Vorsprünge an der zweiten Permanentmagneteinrichtung oder an der magnetisierbaren Scheibe angeordnet sein.

Diese nockenartigen Vorsprünge können beispielsweise die Form einer Kugel oder die Form eines in radialer Richtung verlaufenden Steges aufweisen. Auch andere, dem Fachmann bekannte Ausbildungen der nockenartigen Vorsprünge zum Abtasten einer Steuerfläche sind erfindungsgemäß möglich.

Die Einstellung der Anziehungskraft zwischen der magnetisierbaren Scheibe und der zweiten Permanentmagneteinrichtung kann beispielsweise über die axiale Höhe der nockenartigen Vorsprünge realisiert sein. Auch hierdurch kann der taktile Eindruck verändert werden, da die Reibung zwischen den gegeneinander bewegten Oberflächen auch von der Kraft zwischen diesen abhängt. Soweit diese Vorsprünge am Permanentmagneten angeordnet sind, können diese auch ein zum Permanentmagneten selbst unterschiedliches Material umfassen, das bezüglich der Härte auf die zugeordnete Anlagefläche, insbesondere auf die Härte des Scheibenmaterials angepasst ist, um einen erhöhten Verschleiß an einer Oberfläche zu vermeiden.

Insofern liegt es auch im Rahmen der Erfindung, wenn die magnetisierbare Scheibe und ein Permanentmagnet der zweiten Permanentmagneteinrichtung nicht direkt zur Anlage gebracht sind, sondern indirekt, beispielsweise auch aufgrund einer Beschichtung des Permanentmagneten oder einer Zwischenlage zwischen dem Permanentmagneten und der magnetisierbaren Scheibe, wobei diese Beschichtung, diese Zwischenlage, etc die Magnetfeldlinien des Permanentmagneten nicht oder wenig beeinflussen, um die gewünschte Wirkung auf die magnetisierbare Scheibe zu erzielen.

Durch die beschriebene Gestaltung der beiden zueinander bewegten und aneinander anliegenden Oberflächen kann eine bei der erfindungsgemäß ausgebildeten Verstelleinrichtung prinzipiell beliebige Haptik erzeugt werden.

Erste, zweite oder die integral ausgebildete Permanenteinrichtung kann als kunststoffgebundenes Verbundteil im Spritzgussverfahren kostengünstig ausgebildet sein.

Zur Gestaltung der magnetisierbaren Scheibe sind prinzipiell alle Materialien geeignet, welche sich magnetisieren lassen, wie beispielsweise Weicheisen oder Stahl. Besonders zweckmäβig durch die Verwendung eines kostengünstigen Umformprozesses kann die Scheibe aus einem Blech, beispielsweise in Form eines Tiefziehprozesses, eines Prägeprozesses oder eines Fließpressprozesses hergestellt sein. Die beschriebenen Verfahren eignen sich insbesondere auch zur Gestaltung einer gewünschten Oberflächenstruktur zur beschriebenen Wechselwirkung mit der zugeordneten Oberfläche an der zweiten Permanentmagneteinrichtung bei der relativen Bewegung zueinander. Insbesondere lässt sich so die beschriebene, in Umfangsrichtung segmentierte, axiale Strukturierung oder die nockenartigen Vorsprünge erzeugen.

Zur Erhöhung der Funktionalität der erfindungsgemäßen Stellvorrichtung kann vorgesehen sein, dass der Drehknopf zur zusätzlichen Bereitstellung einer Tastschalter- oder Rastschalterfunktion eine Auslöseeinrichtung aufweist, welche mit der ersten Permanentmagneteinrichtung in mechanischer Wirkverbindung steht zum axialen Bewegen eines Permanentmagneten der ersten Permanentmagneteinrichtung, wobei der Permanentmagnet in axialer Richtung zwangsgeführt ist und ferner die Sensoreinrichtung zur Erfassung einer Magnetfeldstärke ausgebildet ist. Diese Ausführungsform unterscheidet sich insofern von den zuvor beschriebenen dadurch, dass der Permanentmagnet der ersten Permanentmagneteinrichtung näher an die Sensoreinrichtung zur Erhöhung der Feldstärke hinbewegt werden kann, was von der Sensoreinrichtung detektiert wird. Dabei sollte die axiale Verschiebung des Permanentmagneten durch die Betätigung der Auslöseeinrichtung größer sein als eine eventuelle axiale Verschiebung während bzw. durch die Drehbewegung des Drehknopfs.

Vorteilhafterweise wird bei dieser Ausführungsform der Permanentmagnet, welcher für die Erfassung der Drehstellung des Drehknopfs verwendet wird, gleichzeitig auch zur Realisierung einer Tastschalter- oder Rastschalterfunktion genutzt. Um eine Veränderung des Drehstellung des Drehknopfs beim Auslösen der Schalterfunktion zu verhindern, ist der Permanentmagnet, welcher der Sensorvorrichtung zugeordnet ist, in axialer Richtung zwangsgeführt, d.h. in Richtung axial zum Drehknopf.

In einer besonders einfachen Ausführungsform ist die Auslöseeinrichtung stabförmig ausgebildet, wobei sich diese radial mittig und axial verschiebbar im Drehknopf erstreckt und wobei an ihrem einen stirnseitigen Ende eine Betätigungsfläche angeordnet ist und an dem anderen stirnseitigen Ende einen Permanentmagneten der ersten Permanentmagneteinrichtung trägt. Zur Bereitstellung einer Verdrehsicherheit der stabförmigen Auslöseeinrichtung kann beispielsweise vorgesehen sein, dass diese an ihrer äußeren Mantelfläche Vorsprünge aufweist, welche in eine zugeordnete Nut am Drehknopf bewegbar angeordnet sind. Dabei kann es auch vorgesehen sein, dass in einer Umkehrung dieser Gestaltung die Nut an der stabförmigen Auslöseeinrichtung angeordnet ist.

Um eine Ruhestellung für die Auslöseeinrichtung bereitzustellen kann vorgesehen sein, dass der Drehknopf eine axial verlaufende, zylinderförmige Öffnung zur zumindest abschnittsweisen Aufnahme der Auslöseeinrichtung aufweist, wobei die Öffnung zu ihrem zum Basisteil hin gerichteten Ende durch einen radialen Flansch begrenzt ist, der als Anlagefläche für eine dem Permanentmagneten zugeordnete Anlagefläche ausgebildet ist. Je nach Ausführungsform kann dabei die zugeordnete Anlagefläche des Permanentmagneten eine direkte Fläche des Magneten selbst, jedoch in einer anderen Ausführungsform auch eine Anlagefläche eines Teils sein, an dem der Magnet befestigt ist.

Um eine stabile Ruhestellung der Auslöseeinrichtung bereitzustellen, bei welcher eine dem Permanentmagnet der ersten Permanentmagneteinrichtung zugeordnete Anlagefläche an einer Gegenfläche innerhalb des Drehknopfs anliegt, kann ein Magnetmittel zur Erzeugung einer axial wirkenden magnetischen Anziehungskraft vorgesehen sein. Durch diese Maßnahme wird eine Rückholkraft entgegen der Betätigungsrichtung erzeugt, was insbesondere vorteilhaft bei der Ausbildung einer Tastfunktion ist. Die Auslöseeinrichtung geht hierdurch nach einer Betätigung selbsttätig in die beschriebene Ruhelage zurück.

Der Fachmann erkennt, dass bei einer gleichwirkenden und gleichwertigen Ausführungsform die beschriebene Einstellvorrichtung auch als linear arbeitende Stellvorrichtung ausgebildet sein kann. Dabei wird statt eines Drehknopfs ein linear bewegbarer Einsteller eingesetzt, wobei sich die prinzipielle geometrische Ausgestaltung dieser Stellvorrichtung durch Abwickeln der Kreisbewegung beim beschriebenen Drehversteller ergibt.

Die Erfindung wird im Folgenden durch das Beschreiben einiger Ausführungsformen unter Bezugnahme auf die beiliegenden Zeichnungen erläutert, wobei
- Figur 1: eine Ausführungsform der erfindungsgemäß ausgebil- deten Einstellvorrichtung 1 in einer perspektivi- schen Ansicht,
- Figur 2: den Drehknopf 10 der Einstellvorrichtung 1 gemäß Figur 1,
- Figur 3: die Magnetisierungsabschnitte an den stirnseitigen Endflächen des beim Drehknopf gemäß Figur 2 ver- wendeten Permanentmagneten,
- Figur 4: in einer perspektivischen Ansicht das gegenüber dem Drehknopf feststehende Basisteil in Form einer Platine 20,
- Figur 5a: die in Figur 1 dargestellte Einstellvorrichtung 1 in einer Aufsicht,
- Figur 5b: eine Schnittdarstellung der in Figur 5a gezeigten Einstellvorrichtung 1 in der Ebene B-B,
- Figur 6: eine Seitenansicht der in Figur 1 dargestellten Einstellvorrichtung 1,
- Figur 7: die Ausbildung einer zweiten Ausführungsform eines Drehknopfs 10 zum Zusammenwirken mit einem Basis- teil gemäß Figur 4,
- Figur 8: eine Ausführungsform der Erfindung eines Drehstel- lers 100 mit Tasterfunktion,
- Figur 9: den Drehknopf 110 des in Figur 8 dargestellten Drehstellers 100,
- Figur 10: die vom Drehknopf 110 gemäß Fig. 9 aufgenommene Auslöseeinrichtung zur Auslösung einer Tastung,
- Figur 11: das als Platine 120 ausgebildete Basisteil mit angebrachter Sensoreinrichtung 130 und angebrachter Stahlscheibe 140,
- Figur 12a: in einer Aufsicht den in Figur 8 dargestellten Drehsteller 100 mit Tasterfunktion,
- Figur 12b: den Drehsteller 100 gemäß Figur 12a in einer Schnittdarstellung in der Ebene E-E und
- Figur 13: den in Figur 8 dargestellten Drehsteller 100 mit Tastfunktion in einer Seitenansicht
zeigt.

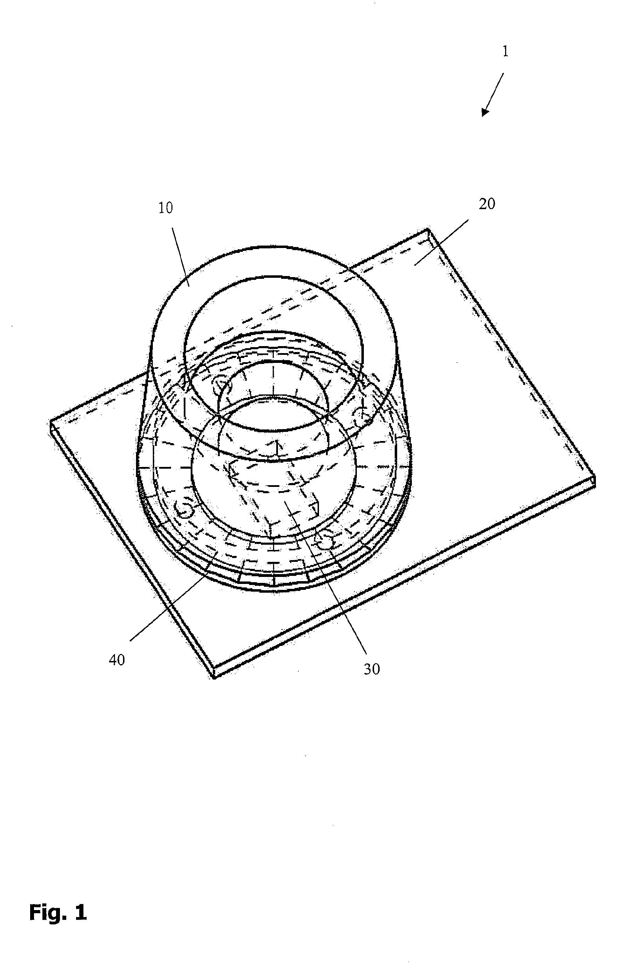

Figur 1 zeigt einen erfindungsgemäß ausgebildeten Drehsteller 1, wie er beispielsweise im Automobilbereich einsetzbar ist. Er umfasst als ein wesentlicher Bestandteil ein als Platine 20 ausgebildetes Basisteil. Die Platine 20 trägt auf der einen Seite eine ringförmige Stahlscheibe 40, die eine axiale Topografie aufweist, d.h. die Höhe der Scheibe variiert in vorgegebener Weise in axialer Richtung über den Umfang. Der Drehknopf 10 liegt mit einer vorgegebenen Anlagefläche in der beschriebenen Ausführungsform auf der ringförmigen Stahlscheibe auf und ist zu dieser und damit zur Platine 20 bzw. dem Sensor 30 drehbar angeordnet. An der der Sensoreinrichtung 30 zugewandten Stirnseite des Drehknopfs 10 weist dieser einen Permanentmagneten auf, der am Ort der Sensoreinrichtung 30 ein Magnetfeld innerhalb der Ebene senkrecht zur Drehachse erzeugt, wobei der durch die Stellung des Drehknopfs eingestellte Magnetfeldwinkel am Ort des Sensors von diesem erfasst wird.

In der beschriebenen Ausführungsform ist die Sensoreinrichtung 30 als herkömmlicher AMR-Sensor ausgebildet, der den anisotropen magnetoresistiven Effekt zur Erfassung eines Feldwinkels nutzt, der von der Drehstellung des Drehknopfs 10 abhängt.

Auf die genaue Gestaltung des Permanentmagneten der Ausführungsform gemäß Figur 1 zur Erzeugung eines Magnetfeldes für den Sensor 30 wird unten stehend näher eingegangen.

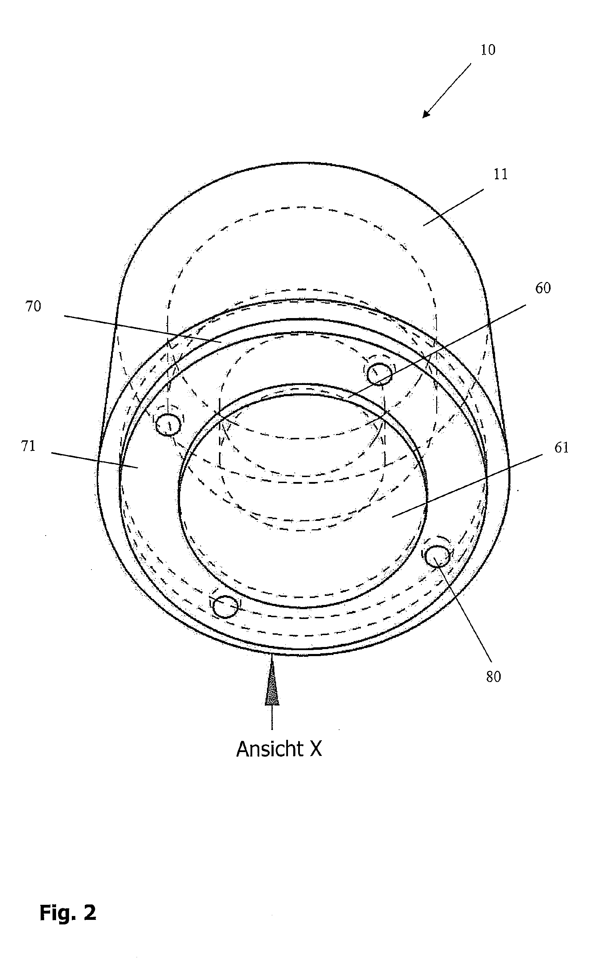

Figur 2 zeigt den Drehknopf 10 der in Figur 1 dargestellten Ausführungsform eines Drehstellers 1 in einer perspektivischen Einzelansicht. An der oberen, der Sensoreinrichtung abgewandten Seite ist der Drehknopf hohl ausgebildet. Die Mantelfläche 11 dient für den Bediener als Angriffsfläche bei der Betätigung des Drehknopfs. In der beschriebenen Ausführungsform ist der Drehknopf 10 einteilig mit einem Permanentmagneten in einem Mehrkomponentenspritzgussverfahren hergestellt, wobei der Drehknopf an seiner im Einbauzustand der Sensoreinrichtung 30 zugewandten Stirnseite den Permanentmagneten aufweist mit verschiedenen Magnetisierungsabschnitten unterschiedlicher Magnetisierung. Dabei wird die erste, auf den Sensor einwirkende Permanentmagneteinrichtung durch einen zentrisch, an der Stirnseite ausgebildeten Podestabschnitt 60 gebildet, die zweite Permanentmagneteinrichtung schließt sich daran radial außen und axial der Zeichnung nach hinten versetzt als Ringabschnitt 70 an, der durch einen Ringflansch 71 stirnseitig begrenzt ist. Die stirnseitige Endfläche des Podestabschnitts 60 ist in der Figur mit dem Bezugszeichen 61 versehen.

Beide stirnseitigen Endflächen 61, 71 sind in der beschriebenen Ausführungsform eben und parallel zueinander gestaltet. Zur Bereitstellung einer Anlage für die mit der Magnetisierung des Ringabschnitts 70 zusammenwirkende Ringscheibe sind in der beschriebenen Ausführungsform umfänglich äquidistant beabstandet vier Anlagekugeln 80 vorgesehen, welche sich in den Magneten hinein erstrecken, jedoch auch aus der Ebene des Ringflansches 71 heraus erstrecken. Diese Anlagekugeln 80 sind aus einem Metall hergestellt, welches in etwa die gleiche Härte besitzen wie das Material der Ringscheibe 40, siehe Figur 1. Die Kugeln können entweder nach der Herstellung des Magnetkörpers in diesen eingebracht, beispielsweise eingeklebt werden, es ist jedoch auch möglich, den Magnetkörper mittels eines Spritzgussverfahrens an die Kugeln anzugießen.

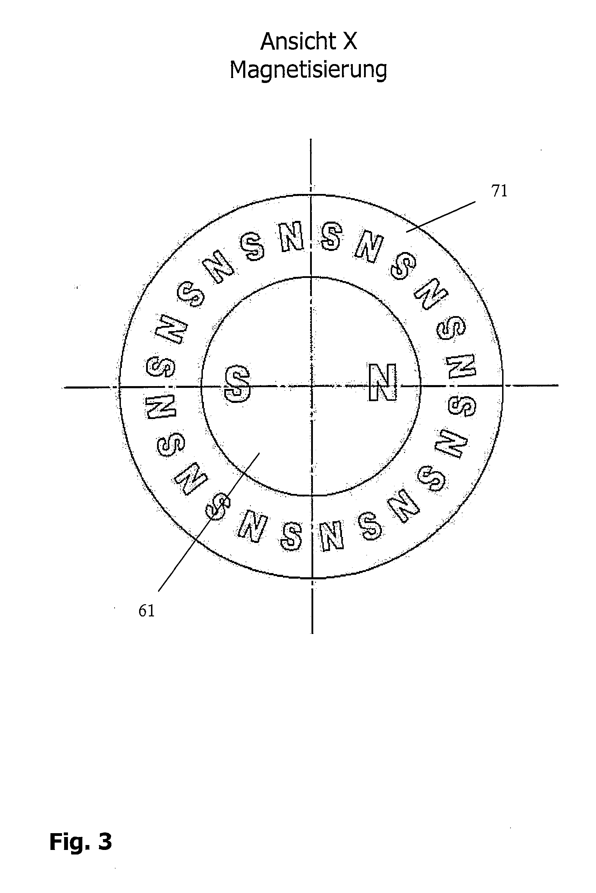

In der beschriebenen Ausführungsform wird die Permanentmagneteinrichtung als kunststoffgebundenes Verbundteil im Spritzgussverfahren hergestellt, wobei ein magnetisierbarer Füllstoff in eine Kunststoffmatrix eingebunden ist. Danach wird der Magnetkörper zur Gestaltung der ersten Permanentmagneteinrichtung, welche das Magnetfeld für die Sensoreinrichtung bereitstellt und die zweite Permanentmagneteinrichtung, welche die Magnetisierung der magnetisierbaren Scheibe bereitstellt, durch herkömmliche Magnetisierungsverfahren erzeugt. Die beispielhafte Anordnung der Magnetisierungsabschnitte zeigt Figur 3, welche die diesbezügliche Ansicht auf die Stirnfläche des Drehknopfs 10 bzw. des Permanentmagneten darstellt. Bei der beschriebenen Ausführungsform erfolgt die Magnetisierung innerhalb der jeweiligen permanentmagnetischen Abschnitte (N,S) senkrecht zur Zeichenebene. Wie aus der Figur ersichtlich, weist der zentrale Podestabschnitt eine zweipolige Magnetisierung, d.h. einen Nord- und einen Südpol auf, während der zu diesem radial außen liegende Ringabschnitt 70 eine Vielzahl von umfänglich aufeinander folgende, gegenpolige Abschnitte umfasst, sodass die dieser Magnetisierung zugeordnete ringförmige Stahlscheibe 40 (siehe Figur 1) ortsabhängig magnetisiert ist.

In einer nicht dargestellten Ausführungsform kann bei der beschriebenen integralen Ausführung der ersten und zweiten Permanentmagneteinrichtung mit einem einteiligen Permanentmagneten auch vorgesehen sein, dass sowohl der innere Stirnabschnitt des Permanentmagneten zur Bereitstellung der ersten Permanentmagneteinrichtung als auch die radial außen liegenden Abschnitte des Permanentmagneten der zweiten Permanentmagneteinrichtung jeweils zur Sensoreinrichtung bzw. zur Ringscheibe hin gerichtet jeweils nur einen einzelnen Nord-/Südpolwechsel aufweisen. Im Gegensatz zur der in Figur 3 angegebenen Ausführungsform, ist dann eine umfängliche Hälfte des Ringflansches 71 als Südpol und die andere Hälfte als Nordpol magnetisiert. Diese wie beschrieben magnetisierten Abschnitte können auch korrespondierend zu dem inneren Stirnabschnitt 61 magnetisiert sein, so dass der Permanentmagnet letztlich auf der in Figur 3 angegebenen gesamten, kreisförmigen Stirnseite zwei halbkreisförmige und gegenpolige Magnetisierungsabschnitte N,S aufweist.

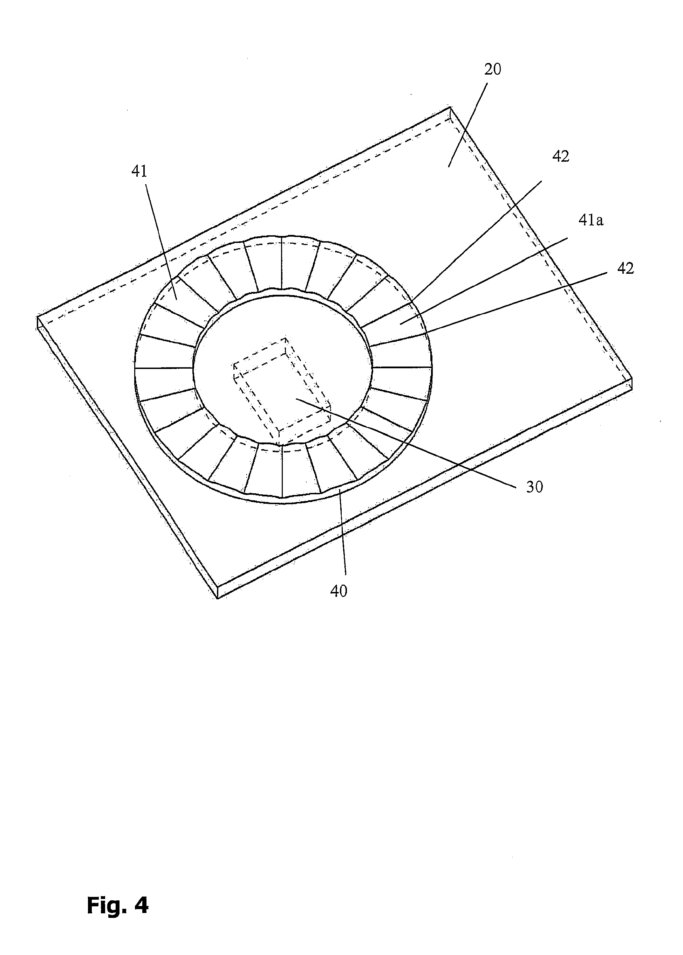

Figur 4 zeigt eine beispielhaft ausgebildete Scheibe 40, die in der erläuterten Ausführungsform auf einer Platine 20 befestigt, beispielsweise angeklebt ist, wobei auf der gegenüber liegenden Seite der Platine der Sensor 30 zentrisch zur Scheibe 40 angeordnet ist. Die der Sensoreinrichtung 30 zugeordnete Auswerteelektronik zur Festlegung der Drehstellung des Drehknopfs ist der Einfachheit halber nicht dargestellt. Die Platine 20 ist aus einem nicht magnetisierbaren Material und vergleichsweise dünn hergestellt, damit die Magnetfeldlinien der ersten Permanentmagneteinrichtung die Platine im Wesentlichen ungestörte durchdringen und zur Sensoreinrichtung 30 gelangen können.

Wie aus Figur 4 ersichtlich, weist die ringförmige Stahlscheibe 40 in Umfangsrichtung an ihrer als Anlagefläche ausgebildete Stirnfläche 41 eine axiale Topografie auf, d.h. die Ausdehnung der Scheibe in axialer Richtung, hier senkrecht zur Platine, ändert sich in Umfangsrichtung. Dargestellt ist eine wellenförmige Strukturierung mit 24 Segmenten 41a, welche jeweils durch Rastlagen 42 begrenzt sind. Diese Rastlagen zeichnen sich dadurch aus, dass die Höhe der Scheibe in diesen Orten ein lokales oder absolutes Minimum einnimmt ist. Die durch die Segmente festgelegte stirnseitige Oberfläche 41 der Scheibe 40 wirkt als Steuerfläche für die in Einbaulage zur Anlage gebrachten Anlagekugeln 80, welche aus dem Ringflansch 71 des Permanentmagneten hervorragen, siehe Figur 2. Dabei sind die Anlagekugeln 80 umfänglich so angeordnet, dass sie bei einer Drehung des Drehknopfs zwar an unterschiedlichen Segmenten 41a der ringförmigen Scheibe 40 anliegen, jedoch immer die gleiche axiale Höhe der Scheibe 40 abtasten. Auf diese Weise wird erreicht, dass der Drehknopf bei seiner Betätigung nicht verkippt. Beim Erreichen einer Rastlage kommen die Anlagekugeln 80 jeweils an einem der Winkellagen 42 zum Ruhen.

Für die stirnseitige Gestaltung der Oberfläche 41 der Scheibe 40, d.h. für die Gestaltung der Steuerfläche der daran bewegten Vorsprünge, welche hier durch die Anlagekugeln 80 bereitgestellt werden, sind je nach gewünschter Haptik auch andere möglich. Beispielsweise können die Segmente 41a eine unterschiedliche umfängliche Erstreckung aufweisen. Darüber hinaus können sie in axialer Richtung beliebig strukturiert sein, d.h. beispielsweise eine trapez-, stufen-, rampenoder auch eine sägezahnartige Struktur neben der in Figur 4 gezeigten wellenartigen Struktur besitzen. Der Fachmann erkennt auch, dass die Steuerfläche in einer Ausführungsform der Erfindung am Drehknopf angeordnet sein kann, demgemäß weist dann die ringförmige magnetisierbare Scheibe Vorsprünge auf, die sich an der Steuerfläche abstützen.

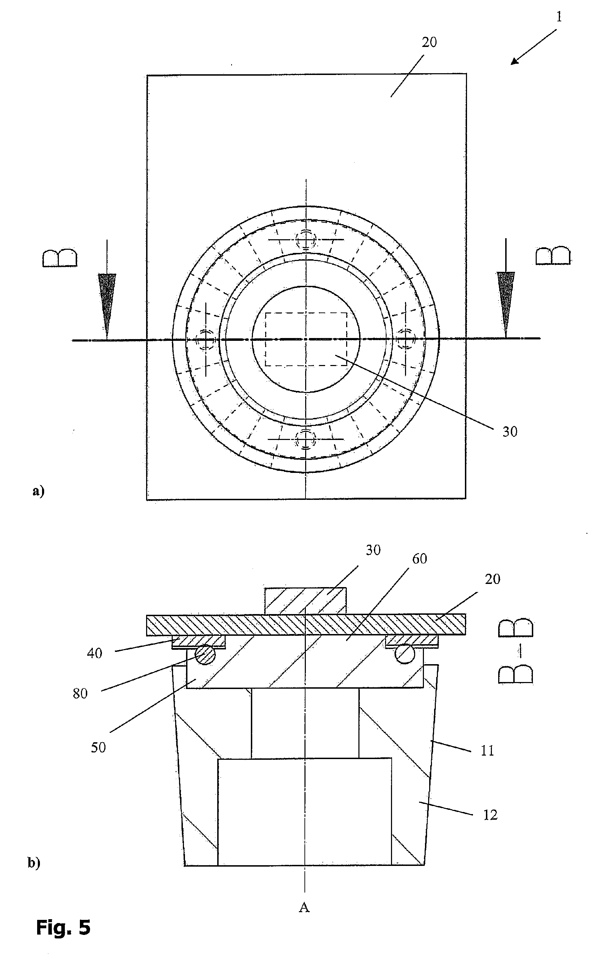

Figur 5a zeigt die Ausführungsform gemäß Figur 1 in einer Aufsicht, Figur 5b zeigt einen Schnitt in der Ebene B-B. Gut zu erkennen ist hier der einteilige Magnetkörper 50 mit den aus der Ringflanschebene herausragenden Anlagekugeln 80, wobei der Podestabschnitt 60 in den inneren Teil der Scheibe 40hineinragt. Ein hohlzylinderförmiges Teil 12 ist zur Bereitstellung einer als Angriffsfläche dienenden Mantelfläche 11 mittels eines Spritzgussverfahrens an den Magnetkörper angegossen zur Gestaltung des Drehknopfs 10.

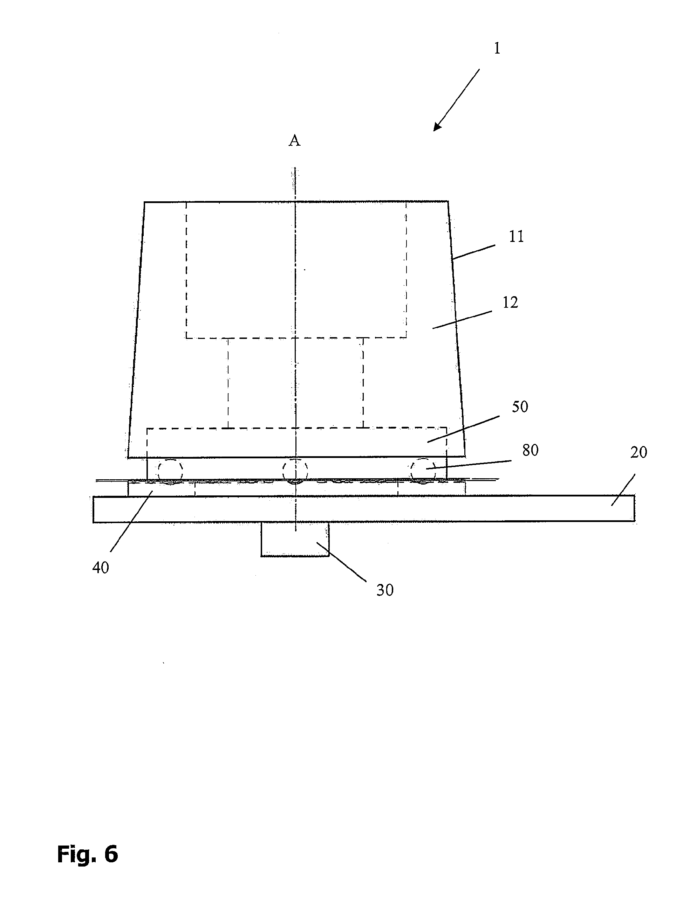

Eine Seitenansicht des Drehstellers 1 gemäß Figur 1 ist in Figur 6 dargestellt.

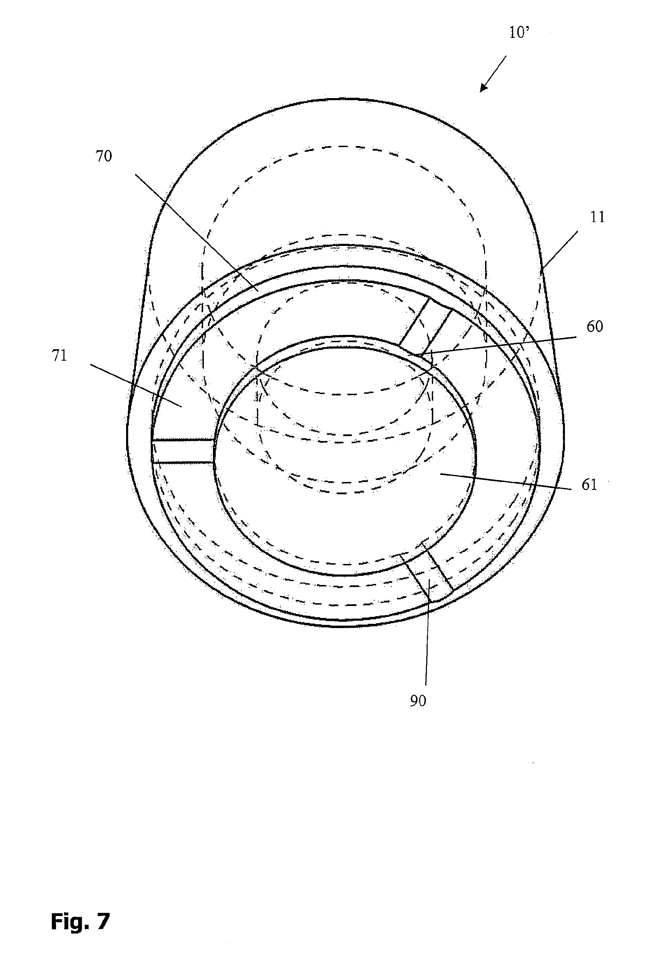

Figur 7 zeigt einen Drehknopf 10' der sehr ähnlich wie der in Figur 2 dargestellte ausgebildet ist. Einzig die komplementäre Anlagefläche zur Ringscheibe 40 ist hier nicht durch Anlagekugeln, sondern durch aus dem Ringflansch 71 hervorstehende, sich radial erstreckende und umfänglich beabstandete Anlagestege 90 bereitgestellt. Da diese mit einer gröβeren Gesamtfläche an der Steuerfläche der Ringscheibe anliegen und somit die Reibung zwischen den gegeneinander bewegbaren Oberflächen erhöht ist, ist die Haptik des Drehknopfs 10' gegenüber dem Drehknopfs 10 verändert.

In einer nicht dargestellten Ausführungsform kann auch vorgesehen sein, dass die Vorsprünge wie Kugeln, Stege oder ähnliche nicht fest, sondern drehbar gemäß einer drehgelagerten Kugel oder Walze oder ähnliche an der einen Oberfläche angebracht sind, so dass die Bewegung der Oberflächen zueinander nicht über eine Gleitbewegung, sondern über eine Rollbewegung zueinander bewegt werden, wodurch sich die Haptik der Vorrichtung stark verändert.

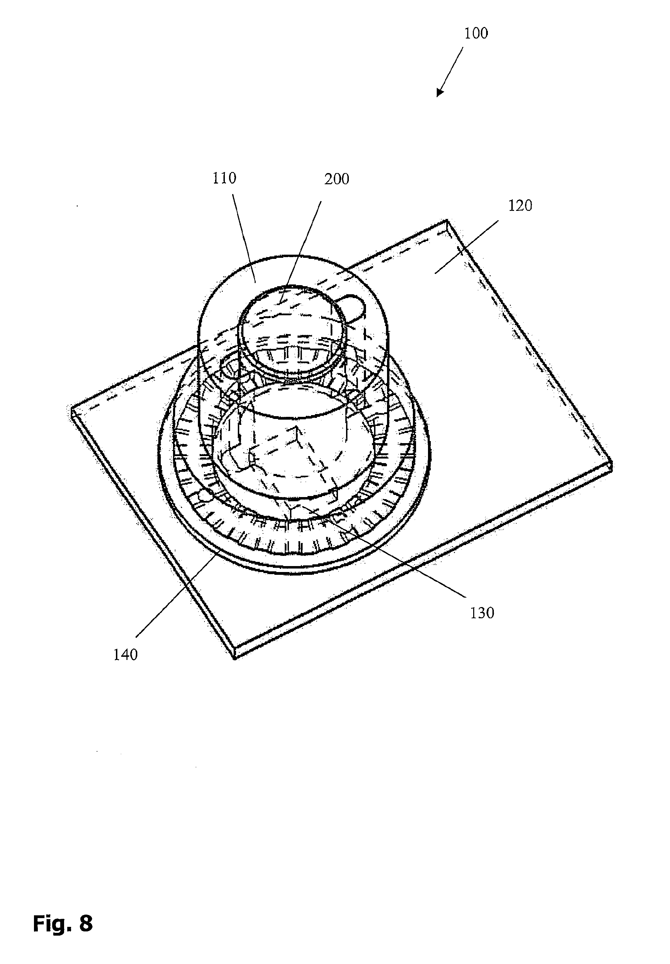

Eine weitere Ausführungsform der erfindungsgemäßen Einstellvorrichtung wird nun mit Bezug auf die Figuren 8 - 13 beschrieben. Gleiche Teile sind bei dieser Ausführungsform in der Regel mit einem Bezugszeichen versehen, das den der bisherigen Ausführungsform + 100 entspricht. Im Gegensatz zu den bisher erläuterten Ausführungsformen ist diese Einstellvorrichtung zusätzlich zur Bereitstellung einer Tastfunktion ausgebildet.

Der Drehsteller mit Tastfunktion 100 ist in einer Prinzipskizze in Figur 8 in einer perspektivischen Ansicht dargestellt. Er weist nun zusätzlich eine Auslöseeinrichtung 200 auf. In der dargestellten Ausführungsform ist die Auslöseeinrichtung stabförmig ausgebildet und erstreckt sich in das Innere des Drehknopfs hinein und ist zu diesem so zwangsgeführt, dass eine relative Verdrehung zum Drehknopf verhindert wird. An ihrem zur Sensoreinrichtung 130 gerichteten stirnseitigen Ende ist die erste Magneteinrichtung in Form eines Permanentmagneten angeordnet zur Erzeugung des wie oben stehend beschriebenen Magnetfeldes am Sensorort. Mit der axialen Verschiebung des Elementes 200 nach unten in Richtung zum Sensor erhöht sich die Feldstärke am Sensor. Insofern ist die Sensoreinrichtung 130 beim Drehsteller 100 mit Tastfunktion nicht nur zur Richtungserfassung der Feldlinien, sondern auch zur Feldstärkeerfassung ausgebildet, sodass die beschriebene Auslenkung des Teils 200 von der Sensoreinrichtung erfasst und mittels der hier auch nicht dargestellten Auswerteelektronik ein zugeordnetes Tastsignal erzeugbar ist.

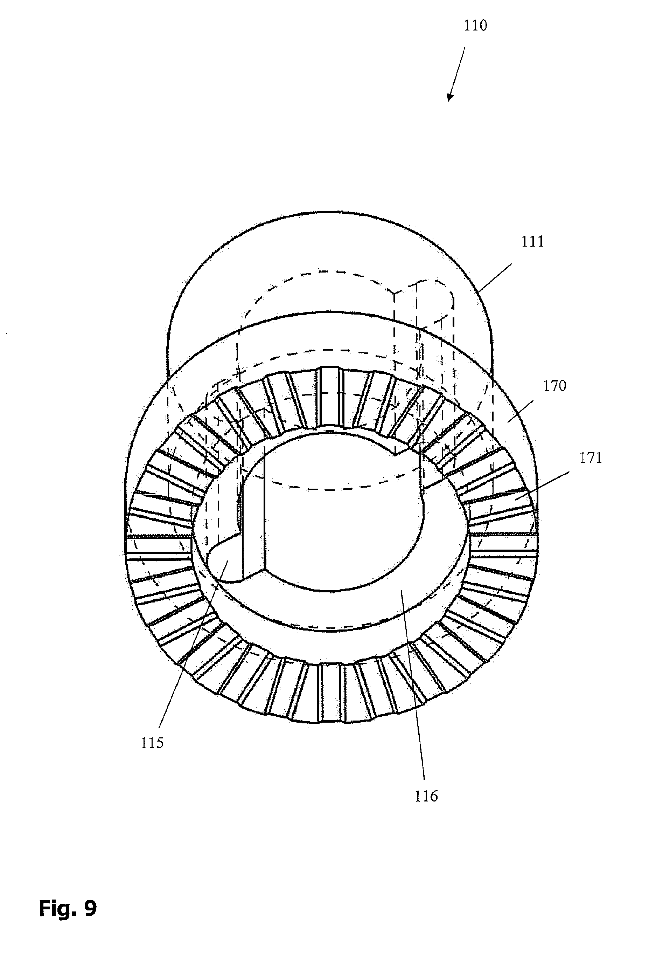

Der Drehknopf 110 des Drehstellers 100 mit Tastfunktion ist in Figur 9 dargestellt. Hier ist die zweite Permanentmagneteinrichtung, d.h. die Magneteinrichtung, welche mit der noch unten stehend zu diskutierenden magnetisierbaren Scheibe zur Erzeugung einer Anziehungskraft zusammenwirkt, getrennt von der ersten Magnetisierungseinrichtung, welche an dem Innenteil 200 angeordnet ist. Der die zweite Magnetisierungseinrichtung darstellende Ringabschnitt 170 weist an seiner Stirnfläche einen in axialer Richtung strukturierten Ringflansch 171 auf. Diese Strukturierung ist in der beschriebenen Ausführungsform zusammen mit dem Magnetkörper, beispielsweise durch ein Spritzgussverfahren hergestellt. Der strukturierte Ringflansch 171 wirkt dementsprechend mit in diesem Fall an der magnetisierbaren Scheibe angeordneten Vorsprünge zur Erzielung der gewünschten Haptik zusammen. Bezüglich der geometrischen Gestaltung und der Anordnung von Steuerfläche und zugeordneten Vorsprüngen wird auf die mit Bezug auf die Figuren 1 - 7 beschriebene Ausführungsformen verwiesen.

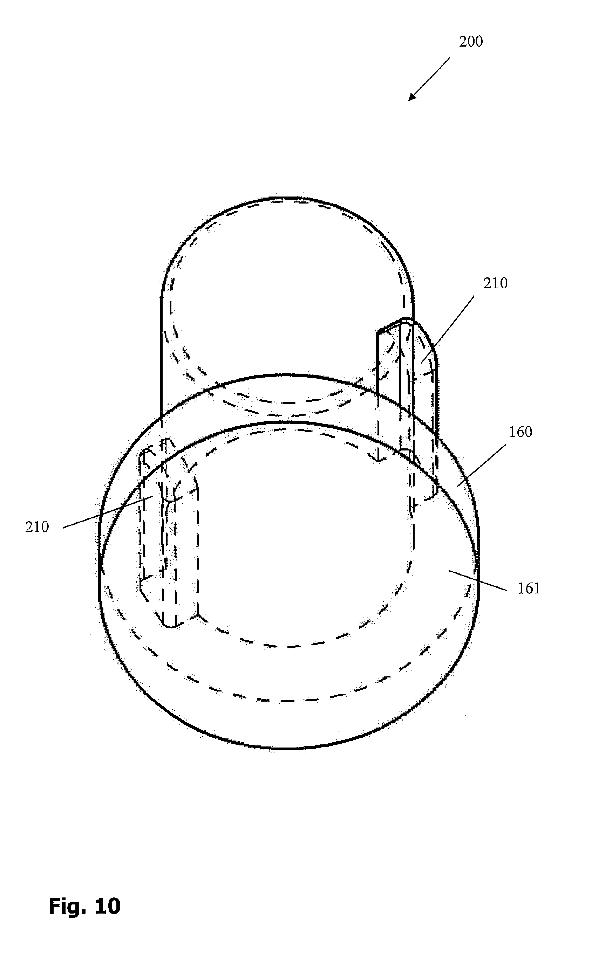

Zur axialen Führung und zur Vermeidung einer Drehung des stabartigen Innenteils 200 weist der Drehknopf zumindest eine, hier zwei gegenüber liegende Nuten 115 im Innenmantel auf zur Aufnahme eines zugeordneten Steges 210 an der stabförmigen Auslöseeinrichtung 200, siehe Figur 10.

Der strukturierte Ringflansch 171 weist die gleiche beispielhafte in Figur 3 für den Ringflansch 71 gezeigte Abfolge von Magnetisierungsabschnitten N/S auf.

Figur 10 zeigt die stabförmige Auslöseeinrichtung 200 in einer Einzeldarstellung, und ist einteilig als kunststoffgebundenes Verbundteil im Spritzgussverfahren hergestellt, wobei die schon beschriebenen axial verlaufenden Stege 210 zur Aufnahme in den zugeordneten Nuten 115 im Drehknopf angeformt sind. Die in der Figur nicht dargestellte Magnetisierung im Podestabschnitt 160 bzw. an der Stirnfläche 161 entspricht der in Figur 3 mit Bezug auf die Fläche 61 angegebene. Demnach entsprechen sich erste und zweite Permanentmagneteinrichtung der Ausführungsformen gemäß Figur 1 und Figur 8. Der wesentliche Unterschied besteht darin, dass bei der hier beschriebenen Ausführungsform beide Permanentmagneteinrichtungen zueinander verschiebbar gestaltet sind, um die beschriebene Tastfunktion bereitzustellen.

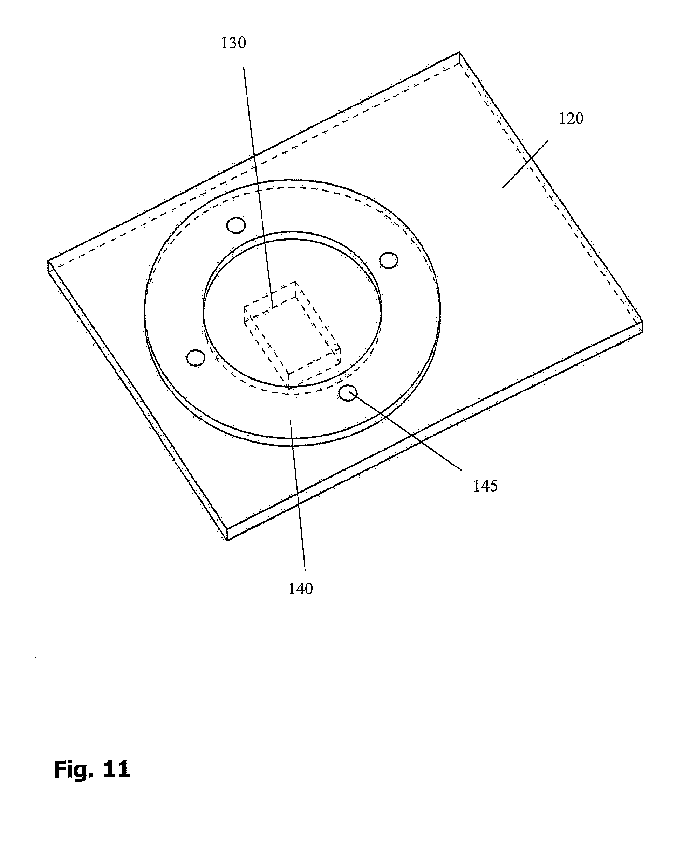

Figur 11 zeigt das Basisteil 120 des Drehstellers mit Tastfunktion gemäß Figur 8, wobei an der einen Seite wiederum eine ringförmige Stahlscheibe 140 befestigt und auf der gegenüberliegenden Seite die Sensoreinrichtung 130 mittig zur Scheibe 140 angeordnet ist. Bei der hier beschriebenen Ausführungsform ist die Ringscheibe 140 im Wesentlichen eben ausgebildet, sie weist zusätzlich vier integral mit der Scheibe hergestellte Vorsprünge 145 auf, welche bei der Drehung des Drehknopfs 110 zum Basisteil auf dem strukturierten Ringflansch 171 des Drehknopfs 110 bewegt werden, siehe Figur 9.

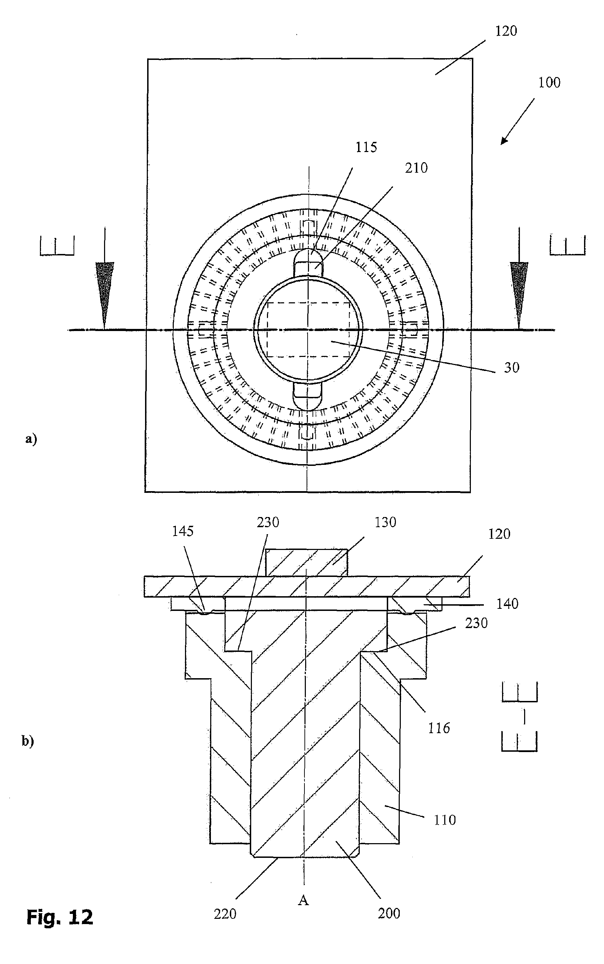

Figur 12a zeigt den in Figur 8 dargestellten Drehsteller 100 mit Tastfunktion in einer Aufsicht, wobei deutlich die Aufnahme der axialen Stege 210 am stabförmigen Innenteil durch die Nuten 115 am Innenmantel des Drehknopfs 110 zu erkennen sind.

Figur 12b zeigt einen Schnitt parallel zur Achse der in Figur 12a dargestellten Ebene E-E. Die Schraffuren zeigen an, dass sowohl das Innenteil 200 als auch der Drehknopf 110 einteilig und homogen aufgebaut sind. Das Innenteil 200 ist durch Druck auf die Auslösefläche 220 in Richtung zur Platine 120 verschiebbar, um die Tastfunktion bereitzustellen. Beide Teile 200, 110 sind aus einem magnetisierbaren Verbundwerkstoff hergestellt, der ortsabhängig magnetisierbar ist. Um eine stabile Ruhelage der Auslöseeinrichtung 200 bereitzustellen, ist an den einander zugeordneten Anlageflanschen 116 des Drehknopfs 110 bzw. 230 des Innenteils 200 eine gegenpolige Magnetisierung realisiert, so dass eine Anziehungskraft erzeugt wird, durch welche das Innenteil 200 mit seiner Anlagefläche 230 an der zugeordneten Anlagefläche 116 des Drehknopfs anliegt. Die Anziehungskraft zwischen den beiden genannten Teilen ist dabei so eingestellt, dass nach dem Auslösen der Tastfunktion das Innenteil 200 wieder in seine in Figur 12b dargestellte Ruheposition zu liegen kommt.

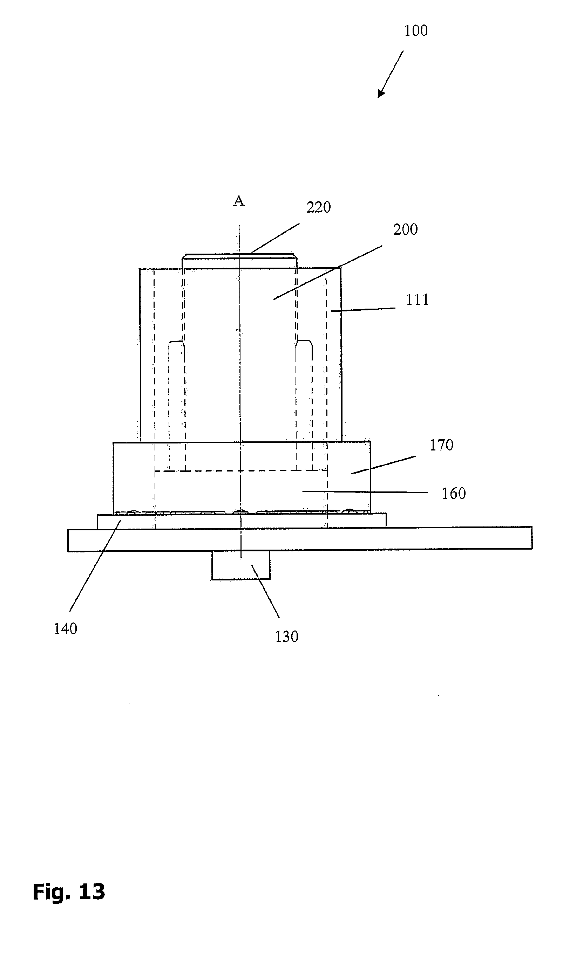

Figur 13 zeigt den in Figur 8 dargestellten Drehsteller mit Tastfunktion in einer Seitenansicht.

Es sei noch darauf hingewiesen, dass die in den Figuren 1 und 8 in der Gesamtdarstellung gezeigten erfindungsgemäßen Einstellvorrichtungen in Prinzipskizzen gezeigt sind. Insbesondere sind bei einer realen Ausführungsform Gestaltungsmittel vorgesehen um zu verhindern, dass der Drehknopf 10, 110 einfach von der feststehenden Platine abgezogen werden kann.

### Bezugszeichenliste

- 1: Drehsteller
- 10, 10': Drehknopf
- 11: Mantelfläche
- 12: Hohlzylinderteil
- 20: Basisteil, Platine
- 30: Sensoreinrichtung
- 40: Ringförmige Stahlscheibe
- 41: Stirnfläche
- 41a: Segment
- 42: Rastlage
- 50: Magnetkörper
- 60: Podestabschnitt
- 61: Stirnfläche
- 70: Ringabschnitt
- 71: Ringflansch
- 80: Anlagekugel
- 90: Anlagesteg
- 100: Drehsteller mit Tastfunktion
- 110: Drehknopf
- 111: Mantelfläche
- 115: Nut
- 116: Anlagefläche
- 120: Platine
- 130: Sensoreinrichtung
- 160: Permanentmagnet
- 140: Stahlscheibe
- 145: Integraler Vorsprung
- 170: Ringabschnitt
- 171: Ringflansch
- 200: stabförmige Auslöseeinrichtung
- 210: Axialer Steg
- 220: Auslöse-/Druckfläche
- 230: Anlagefläche
- A: Achse

## Patentansprüche

1. Einstellvorrichtung (1, 100) zur manuellen Einstellung eines Sollwertes mit einem Drehknopf (10, 10', 110), einem gegenüber dem Drehknopf feststehenden Basisteil (20, 220), sowie einer am Drehknopf befestigten und mit diesem relativ zum Basisteil bewegbaren ersten Permanentmagneteinrichtung und einer an dem Basisteil angeordneter Sensoreinrichtung (30, 130) mit zugeordneter Auswerteelektronik zur Erfassung einer Drehstellung des Drehknopfs (10, 10', 110), **dadurch gekennzeichnet, dass** eine ringförmige Scheibe (40, 140) aus magnetisierbarem Material vorgesehen ist, welche mit einer dieser zugeordneten zweiten Permanentmagneteinrichtung zur Erzeugung einer sich zwischen der magnetisierbaren Scheibe (40, 140) und der Permanentmagneteinrichtung einstellenden axialen magnetischen Anziehungskraft zusammenwirkt, wobei die magnetisierbare Scheibe und die zweite Permanentmagneteinrichtung in Einbaulage auf Anlage und bewegbar zueinander angeordnet sind und aneinander anliegende Oberflächen (80, 90, 41; 171, 145) der magnetisierbarer Scheibe (40, 140) und der zweiten Permanentmagneteinrichtung zur Einstellung einer vorgegebenen Haptik bei der Betätigung des Drehknopfes (10, 10', 110) gestaltet sind.

2. Stellvorrichtung (1, 100) nach Anspruch 1, **dadurch gekennzeichnet , dass** die magnetisierbare Scheibe (40, 140) an dem feststehenden Basisteil (20, 120) befestigt und die zweite Permanentmagneteinrichtung am Drehknopf (10, 10', 110) befestigt ist.

3. Stellvorrichtung nach Anspruch 1 oder 2, **dadurch gekennzeichnet ,dass** die magnetisierbare Scheibe zentrisch zur Drehachse des Drehknopfs an diesem befestigt ist und die zweite Permanentmagneteinrichtung an dem Basisteil befestigt ist.

4. Stellvorrichtung (1, 100) nach einem der Ansprüche 1, 2 oder 3, **dadurch gekennzeichnet, dass** die erste Permanentmagneteinrichtung einen Permanentmagneten (50, 160) umfasst, der auf der zur Sensoreinrichtung gerichteten Stirnseite eine 2-polige Magnetisierung aufweist und dass die Sensoreinrichtung (30, 130) einen Magnetfeldwinkel des von dem Permanentmagneten (50, 160) erzeugten Magnetfeldes innerhalb der Ebene senkrecht zur Drehachse (A) erfasst.

5. Stellvorrichtung (1) nach einem der Ansprüche 1, 2 oder 4, **dadurch gekennzeichnet, dass** die erste Permanentmagneteinrichtung und die zweite Permanentmagneteinrichtung zusammen als einteiliger Permanentmagnet (50) ausgebildet sind, wobei zur Gestaltung einer der magnetisierbaren Scheibe zugeordneten zweiten Permanentmagneteinrichtung radial außen liegende Abschnitte (70) des Permanentmagneten (50) eine umfänglich angeordnete mehrpolige, zumindest zweipolige Magnetisierung aus radialen Segmenten, insbesondere mit einer Abfolge von Nord- und Südpolen, zur magnetisierbaren Scheibe hin aufweisen.

6. Stellvorrichtung (1) nach Anspruch 5, **dadurch gekennzeichnet, dass** der einteilige Permanentmagnet (50) auf der zur Sensoreinrichtung (30) gerichteten Stirnseite eine 2-polige Magnetisierung aufweist, wobei die Magnetisierung im inneren Bereich (61) der Stirnfläche gegenüber der Sensoreinrichtung (30) entsprechend der ersten Permanentmagnetfeldeinrichtung ein Magnetfeld innerhalb der Ebene senkrecht zur Drehachse (A) für die Sensoreinrichtung (30) erzeugt und die Magnetisierung im gegenüber der magnetisierbaren Scheibe gelegenen Bereich (71) entsprechend der zweiten Permanentmagneteinrichtung eine Kraftwirkung auf die Scheibe bewirkt.

7. Stellvorrichtung (1, 100) nach einem der Ansprüche 1 bis 6, **dadurch gekennzeichnet, dass** sich die erste Permanentmagneteinrichtung axial in einen Innenbereich der ringförmigen magnetisierbaren Scheibe (40, 140) zur Zentrierung des Drehknopfs (10, 10', 100) hinein erstreckt.

8. Stellvorrichtung (1, 100) nach einem der Ansprüche 1 bis 7, **dadurch gekennzeichnet, dass** die zugeordneten, aneinander anliegenden Oberflächen (80, 90, 41; 171, 145) von magnetisierbarer Scheibe (40, 140) und zweiter Permanentmagneteinrichtung zur Bereitstellung einer Vielzahl von Raststellungen (42) bei einer gegenseitigen Verdrehung zueinander ausgebildet sind zur Gestaltung einer rastenden Haptik des Drehknopfes (10, 10', 100).

9. Stellvorrichtung (1, 100) nach Anspruch 8, **dadurch gekennzeichnet, dass** eine der aneinander anliegenden Oberflächen (41; 171) in Umfangsrichtung eine axiale Struktur, wie eine trapez-, rampen-, stufen-, sägezahn- oder wellenartige Struktur aufweist, die als Steuerfläche für mehrere umfänglich beabstandete, nockenartige und an der zugeordneten Oberfläche angeordnete Vorsprünge (80, 90; 145) ausgebildet sind.

10. Stellvorrichtung (1, 100) nach einem der Ansprüche 8 oder 9, **dadurch gekennzeichnet, dass** sich der Drehknopf (10, 10', 100) bei seiner Betätigung aufgrund einer vorgegebenen Gestaltung der aneinander liegenden Oberflächen (80, 90, 41; 171, 145) von magnetisierbarer Scheibe und zugeordneter Permanentmagneteinrichtung zwischen benachbarten Raststellungen axial zum Basisteil (20, 120) verschiebt, wobei die axiale Lage des Drehknopf zum Basisteil bei einer Mehrzahl von einstellbaren Rastungen (42), insbesondere bei allen einstellbaren Rastungen im Wesentlichen gleich ist.

11. Stellvorrichtung (1, 100) nach einem der Ansprüche 1 bis 10, **dadurch gekennzeichnet, dass** eine Permanentmagneteinrichtung (50) als kunststoffgebundenes Verbundteil im Spritzgussverfahren ausgebildet ist.

12. Stellvorrichtung (1, 100) nach einem der Ansprüche 1 bis 11, **dadurch gekennzeichnet, dass** der Permanentmagnet (50) mit dem Drehknopf (10, 10') im Mehrkomponentenspritzgussverfahren integral ausgebildet ist.

13. Stellvorrichtung (1, 100) nach einem der Ansprüche 1 bis 12, **dadurch gekennzeichnet, dass** die magnetisierbare Scheibe (40, 140) über einen Umformprozess aus einem Blech, zum Beispiel als ein Tiefziehblech, geprägtes Blech oder Fließpressteil ausgebildet ist.

14. Stellvorrichtung (100) nach einem der Ansprüche 1 bis 13, **dadurch gekennzeichnet, dass der** Drehknopf (110) zur zusätzlichen Bereitstellung einer Tastschalter- oder Rastschalterfunktion eine Auslöseeinrichtung aufweist, welche mit der ersten Permanentmagneteinrichtung in mechanischer Wirkverbindung steht zum axialen Bewegen eines Permanentmagneten der ersten Permanentmagneteinrichtung, wobei der Permanentmagnet in axialer Richtung zwangsgeführt ist und ferner die Sensoreinrichtung (130) zusätzlich zur Erfassung eines Magnetfeldwinkels zur Erfassung einer Magnetfeldstärke ausgebildet ist.

15. Stellvorrichtung (100) nach Anspruch 14, **dadurch gekennzeichnet, dass** die Auslöseeinrichtung (200) stabförmig ausgebildet ist und sich radial mittig und axial verschiebbar im Drehknopf (110) erstreckt, und an ihrem einen stirnseitigen Ende eine Betätigungsfläche (220) und an dem anderen stirnseitigen Ende den Permanentmagneten der ersten Permanentmagneteinrichtung trägt.

16. Stellvorrichtung (100) nach einem der Ansprüche 14 oder 15, **dadurch gekennzeichnet, dass** der Drehknopf (110) eine axial verlaufende, zylinderförmige Öffnung zur zumindest abschnittsweisen Aufnahme der Auslöseeinrichtung (200) aufweist, wobei die Öffnung zu ihrem zum Basisteil hin gerichteten Ende durch einen radialen Flansch (116) begrenzt ist, der als Anlagefläche für eine dem Permanentmagneten zugeordnete Anlagefläche (230) ausgebildet ist.

17. Stellvorrichtung nach einem der Ansprüche 14 bis 16, **dadurch gekennzeichnet, dass** ein Magnetmittel zur Erzeugung einer axial wirkenden magnetischen Anziehungskraft vorgesehen ist zur Einstellung einer Ruhestellung der Auslöseeinrichtung (200), bei welcher eine dem Permanentmagnet zugeordnete Anlagefläche (230) an einer Gegenfläche (116) innerhalb des Drehknopfs anliegt.
